# EUROPEAN PATENT APPLICATION

(11) **EP 1 471 605 A2**
(43) Date of publication of application: **27.10.2004**
(21) Application number: 04007992.3
(22) Date of filing: 01.04.2004
(51) Int. Cl.: H01R 12/04

(54) **Electronic circuit unit having mounting structure with high soldering reliability**

(30) Priority: 18.04.2003 JP 2003114716
(71) Applicant: ALPS ELECTRIC CO., LTD., Tokyo 145-8501 (JP)
(72) Inventor: Saito, Yoshio, Ota-ku Tokyo 145-8501 (JP); Ito, Shigehiro, Ota-ku Tokyo 145-8501 (JP)
(74) Representative: Klunker . Schmitt-Nilson . Hirsch

(57) **Abstract**

According to the present invention, an electronic circuit unit is provided, by which, when an electronic circuit unit is mounted to a mother substrate, soldering reliability is enhanced and the shielding effect between the electronic circuit unit and the mother substrate is improved. The electronic circuit unit comprises a circuit board 1 having an upper face on which electronic components 2 are mounted and a lower face having a plurality of first land portions 3, and a connector member 4 disposed at a lower portion of the circuit board 1, wherein the connector member 4 has an insulating resin portion 4a, a metallic shield plate 5 embedded in the insulating resin portion 4a, and connector terminals 6 which are provided with first terminals 6a protruding from an upper face of the insulating resin portion 4a and second terminals 6c protruding from a lower face of the insulating resin portion 4a, and the connector terminals 6 are configured such that the first terminals 6a over the upper face are electrically connected to the first land portions 3 and the second terminals 6c over the lower face are electrically connectable to second land portions 11 of a mother substrate 10.

## Description

### BACKGROUND OF THE INVENTION

### 1. Field of the Invention

The present invention relates to an electronic circuit unit that is suited to a transceiver unit, for example, used for an electric toll collection system (ETC) or a cellular phone, etc.

### 2. Description of the Related Art

The structure of a conventional electronic circuit unit is shown in Fig. 7. Fig. 7 is a side view of the conventional electronic circuit unit.

In the drawing, the circuit board 51 is formed of epoxy resin or ceramic material, etc., and consists of one layer board or a multilayer board. Although not illustrated in the drawing, various electronic components are mounted to form a desired electric circuit on the one face 51a.

In addition, on the other face 51b of the circuit board 51, a plurality of land portions 52 are provided which are connected to the electric circuit on one face 51a, with the land portions 52 serving as lead terminals. With such structure, the electronic circuit unit is formed.

Although the electronic circuit unit is mounted on the set side of a mother substrate 53 of the electronic apparatus, the mother substrate 53 is generally formed of a phenol board or an epoxy resin board. On a surface of the mother substrate 53, land portions 54 are provided to oppose the land portions 52 of the electronic circuit unit.

Furthermore, the solder 55 such as cream solder or ball grid array are provided to the land portions 52, so that they are mounted to the land portions 54 of the mother substrate 53, and land portions 52 and 54 are connected to each other by the solder 55 (for example, see Japanese Unexamined Patent Application Publication No. 9-74267).

However, since the circuit board 51 is often made of different material and thickness from those of the mother substrate 53, there arises a difference in expansion/contraction between the circuit board 51 and the mother substrate 53 by a temperature change under an outer environment, causing cracks in the solder 55 and adversely affecting the reliability of the electrical connections.

Furthermore, there has been a concern that, when it is used in an electronic apparatus for car equipments such as ETC, since it is easily affected by inductive noises such as electromagnetic waves, these inductive noises affect various electronic equipments, which in turn impairs the high frequency characteristics of the electric circuit.

In a conventional electronic circuit unit structure, when the circuit board 51 is made of different material and thickness from those of the mother substrate 53, since the land portions 52 and 54 are soldered by the solder 55, there arises a difference in expansion/contraction between the circuit board 51 and the mother substrate 53 by a temperature change under an outer environment, causing cracks in the solder 55 and adversely affecting the reliability of the electrical connections.

Furthermore, there has been a problem that when it is used for car equipments, since it is easily affected by inductive noises such as electromagnetic waves, these inductive noises affect various electronic compounds, which in turn impairs the high frequency characteristics of the electric circuit.

### SUMMARY OF THE INVENTION

Accordingly, to solve the above-mentioned problems, it is an object of the present invention to provide an electronic circuit unit, by which, when an electronic circuit unit is mounted to a mother substrate, soldering reliability is enhanced and the shielding effect between the electronic circuit unit and the mother substrate is improved.

To solve the above-mentioned problem, as a first means of the present invention, there is provided a structure comprising a circuit board having an upper face on which electronic components are mounted to form a desired electric circuit and a lower surface having a plurality of first land portions connected to the electric circuit; and a connector member disposed at a lower portion of the circuit board; wherein the connector member has an insulating resin portion, a metallic shield plate embedded in the insulating resin portion, and connector terminals which are provided with first terminals protruding from an upper face of the insulating resin portion and second terminals protruding from a lower face of the insulating resin portion; and the connector terminals are configured by the first terminals over the upper face are electrically connected to the first land portions and the second terminals over the lower face are electrically connectable to second land portions of a mother substrate.

Furthermore, as a second means of the present invention, the shield plate has a plurality of cutout portions, and the connector terminals are arranged to pass through the cutout portions vertically without contacting the shield plate.

Furthermore, as a third means of the present invention, the connector member has earth terminals which are electrically connected to the shield plate, and the earth terminals are electrically connectable to the second land portions of the mother substrate.

Furthermore, as a fourth means of the present invention, the connector terminals are made of metallic plates, and are formed by the second terminals deformably extending from an outer surface of the insulating resin portion.

Furthermore, as a fifth means of the present invention, the first land portions and the first terminals are soldered.

Furthermore, as a sixth means of the present invention, the circuit board includes connecting pieces soldered to the first land portions; the connecting pieces are made of metallic thin plates; the connecting pieces have first connections soldered to the first land portions, second connections soldered to the first terminals, and legs linking the first and second connections; and the first land portions and the first terminals are soldered by the legs while they are separated.

### BRIEF DESCRIPTION OF THE DRAWINGS

Fig. 1 is a front view illustrating the electronic circuit unit according to the present invention;
Fig. 2 is a plan view illustrating the connector member of the electronic circuit unit according to the present invention;
Fig. 3 is an enlarged cross-sectional view of main parts showing mounting of the electronic circuit unit of the invention onto a mother substrate;
Fig. 4 is an enlarged cross-sectional view of main parts showing a connection using connecting pieces of the electronic circuit unit of the invention;
Fig. 5 is an enlarged perspective view of a connecting piece of the electronic circuit unit of the invention;
Fig. 6 is an enlarged perspective view of a connecting piece of another preferred embodiment of the invention; and
Fig. 7 is a side view of a conventional electronic circuit unit.

### DESCRIPTION OF THE PREFERRED EMBODIMENT

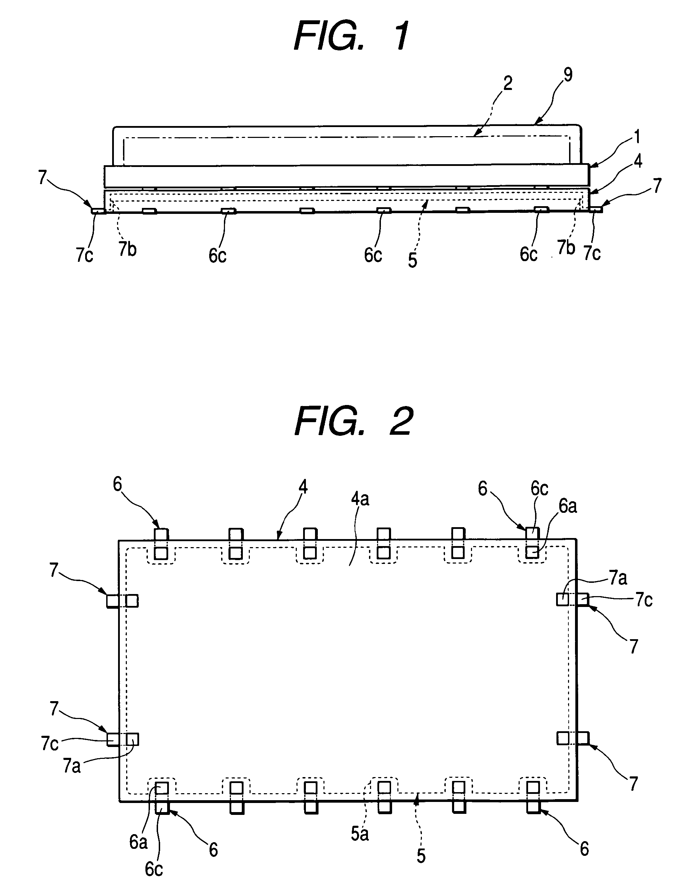

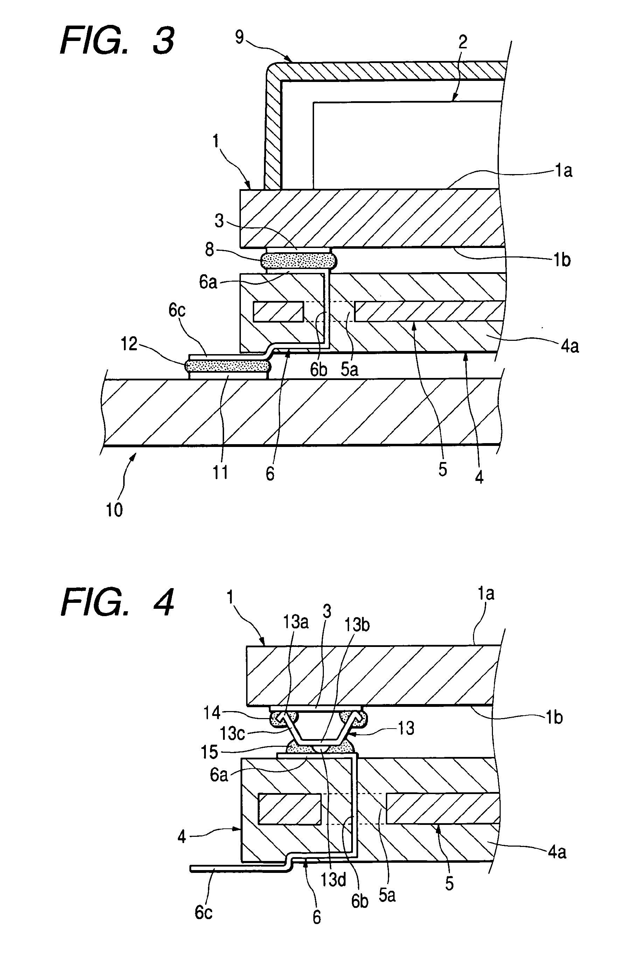

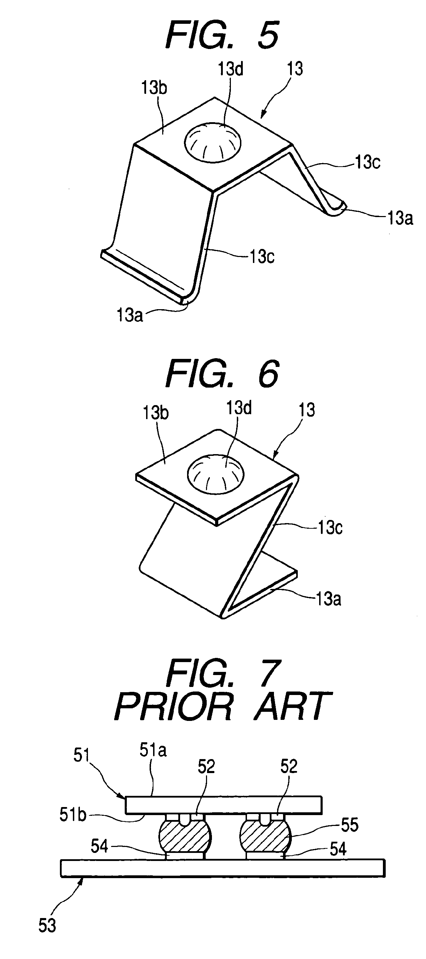

Hereinafter, electronic circuit units according to preferred embodiments of the present invention are shown in Figs. 1 to 6. Fig. 1 is a front view of the electronic circuit unit of the present invention. Fig. 2 is a plan view of a connector member of the electronic circuit unit of the present invention. Fig. 3 is an enlarged cross-sectional view of main parts showing mounting of the electronic circuit unit of the present invention onto a mother substrate. Fig. 4 is an enlarged cross-sectional view of main parts showing a connection using connecting pieces of the electronic circuit unit of the present invention. Fig. 5 is an enlarged perspective view of a connecting piece of the electronic circuit unit of the present invention. Fig. 6 is an enlarged perspective view of a connecting piece of another preferred embodiment of the electronic circuit unit of the present invention.

In Figs. 1 to 3, the circuit board 1 is formed of epoxy resin or ceramic material, etc., and consists of one layer or multi-layer board, and various electronic components 2 are mounted on one face 1a to form a desired electric circuit.

Furthermore, on the other face 1b of the circuit board 1 are provided a plurality of first land portions 3 connected to the electric circuit, with the first land portions forming terminals for outlet drawing. The first land portions 3 are provided so as to be arranged along at least a pair of opposing edges of the circuit board 1.

The connector member 4 comprises an insulating resin portion 4a formed of rectangular, plate-shaped insulating material such as synthetic resin, a metallic shield plate 5 embedded in the insulating resin portion 4a over substantially one face, connector terminals 6 made of metallic plates which extend through the upper and lower faces of the insulating resin portion 4a, and earth terminals 7.

The connector terminals 6, longitudinally arranged along a pair of opposing edges, comprises first terminals 6a formed to protrude from the upper face of the insulating resin portion 4a, and second terminals 6c formed to protrude from the lower face of the insulating resin portion 4a via connecting conductors 6b. Furthermore, the second terminals 6c extend from the outer surface of the lower face of the insulating resin portion 4a so as to be deformable.

Moreover, a plurality of cutout portions 5a are provided to the shield plate 5 so that the connector terminals 6 pass through the cutout portions 5a vertically without contacting the shield plate 5.

With this structure, the shield plate 5 does not contact the connector terminals 6 while the shielding effect is retained with a simple configuration.

Likewise, earth terminals 7, laterally arranged along a pair of opposing edges of the connector member 4, comprise first terminals 7a formed to protrude from the upper face of the insulating resin portion 4a, and second terminals 7c formed to protrude from the lower face of the insulating resin portion 4a via connecting conductors 7b. Moreover, the connecting conductors 7b are electrically connected to the shield plate 5 in the insulating resin portion 4a.

Moreover, the connector member 4 is soldered by the solder 8 while the first terminals 6a of the connector terminals 6 and the first terminals 7a of the earth terminals 7 are opposed to each of the first land portions 3 of the circuit board 1, so that they are mounted integrally to a lower portion of the circuit board 1, by way of being connected to the first land portions 3.

The cover 9, made of a metallic plate, is box-shaped with one end open, and mounted onto the upper face 1a of the circuit board 1 so as to cover the electronic components 2. With this structure, the electronic circuit unit of the present invention is formed.

The above-described electronic circuit unit is used while it is mounted on the set side of the mother substrate 10 of the electronic device. Generally, the mother substrate 10 is comprised of a phenol board or an epoxy resin board, and, on the face of the mother substrate 10 are provided second land portions 11 which oppose the second terminals 6c, 7c of the connector terminals 6 and the earth terminals 7 of the electronic circuit unit.

Furthermore, the second terminals 6c, 7c are mounted by the solder-connection to the second land portions 11 by the solder 12 with the second land portions 11 being mounted on the second terminals 6c, 7c.

Consequently, the electric circuit on the circuit board 1 and the mother substrate 10 are connected via the connector terminals 6 and the earth terminals 7, respectively.

In general, since the circuit board 1 and the mother substrate 10 often have different material or thickness from each other, a difference in expansion/contraction of the circuit board 1 and the mother substrate 10 may arise due to a temperature change in the environment.

In such a case, since the first land portions 3 of the circuit board 1 and the second land portions 11 of the mother substrate 10 are connected to each other via the connector terminals 6 and the earth terminals 7, the connector terminals 6 and the earth terminals 7 accommodate the difference in the expansion/contraction, so that cracks in the solder 8, 12 are prevented, achieving a higher reliability of the electrical connections.

Furthermore, since the shielding effect between the circuit board 1 and the mother substrate 10 is enhanced by the shield plate 5 embedded in the connector member 4, disposed at the lower portion of the circuit board 1, an electronic circuit unit with good high frequency characteristics may be obtained.

Furthermore, by providing the earth terminals 7 electrically connected to the shield plate 5, together with the fact that the earth terminals 7 are capable of being electrically connected to the second land portions 11 of the mother substrate 10, inductive noises such as electromagnetic waves which affect the electronic components of the circuit board 1 can be securely drained to the ground (earth portion) of the mother substrate 10 via the shield plate 5.

Furthermore, since the second terminals 6c, 7c deformably extend from the outer surface of the lower face of the insulating resin portion 4a, the difference in expansion/contraction between the circuit board 1 and the mother substrate 10 is accommodated by deformation of the second terminals 6c, 7c, further enhancing the reliability of the electrical connections.

Therefore, since the first land portions 3 and the first terminals 6a, 7a can be directly soldered by the solder 8, the connection between the circuit board 1 and the connector member 4 becomes a direct contact, and achieves a thinner structure, reducing the size of electronic circuit unit.

Figs. 4 and 5 illustrate a connection configuration using connecting pieces of another embodiment of the electronic circuit unit of the present invention.

In the drawings, the connecting piece 13, made of copper containing phosphorous bronze, for example, is formed of a flexible metallic thin plate, and has a first connection 13a provided at one end, a second connection 13b provided at the other end, a leg 13c which links the first and second connections, and a protruding portion 13d provided at the second connection 13b.

As illustrated in Figs. 4 and 5, the connecting piece 13 according to this embodiment, as a whole, has a trapezoidal shape, with two legs 13c extending from both ends of the second connection 13b, and the first connections 13a having a circular-arc shape being formed at the ends of the legs 13c.

Moreover, the leg 13c may be one, or three or more, and furthermore, the first connection 13a may be flat rather than circular arc.

Furthermore, as for the connecting piece 13, the first connections 13a are soldered to each of the land portions 3 of the circuit board 1 by the solder 14, and the second connection 13b is soldered to each of the first terminals 6a, 7a by the solder 15 so that the circuit board 1 and the connecter member 4 is integrally mounted.

Fig. 6 shows another embodiment of a connecting piece, in which the connecting piece 13 is formed of a band-shaped metallic thin plate which is bent into a Z-letter shape, as a whole, and has a flat first connection 13a, a second connection 13b arranged parallel to the first connection 13a, a leg 13c linking non-opposing edges of the first and second connections 13a, 13b, and a projecting portion 13d provided at the second connection 13b. Also, the projecting portion 13d may be provided at the first connection 13a.

By providing the connecting piece 13 as described above, the first land portions 3 and the first terminals 6a, 7a are soldered by the legs 13c while they are separated, so that, even if there occurs a difference in expansion/contraction between the circuit board 1 and the mother substrate 10 by a temperature change under an outer environment, the legs 13c of the connecting pieces 13 accommodate the difference in the expansion/contraction, giving greater reliability of the electrical connections than a direct connection.

Furthermore, although in the above preferred embodiments, it has been described that the first connections 13a are soldered to the first land portions 3 by the solder 14 and the second connections 13b are soldered to the first terminals 6a, 7a by the solder 15, the first connections 13a may also be soldered to the first land portions 3, and the second connections 13b to the first terminals 6a, 7a.

As described hereinbefore, the electronic circuit unit according to the present invention comprises a circuit board having an upper face on which electronic components are mounted to form a desired electric circuit and a lower face having a plurality of first land portions connected to the electric circuit, and a connector member disposed at a lower portion of the circuit board, wherein the connector member has an insulating resin portion, a metallic shield plate embedded in the insulating resin portion, and connector terminals which are provided with first terminals protruding from an upper face of the insulating resin portion and second terminals protruding from a lower face of the insulating resin portion, and the connector terminals are configured such that the first terminals over the upper face are electrically connected to the first land portions and the second terminals over the lower face are electrically connectable to the second land portions of a mother substrate, whereby, even if a difference in expansion/contraction of the circuit board and the mother substrate arise due to a temperature change under an outer environment, since the first and the second land portions are connected by the connector terminal, the connector terminal accommodates the difference in expansion/contraction, so that cracks in the solder are prevented, resulting in more reliability of the electrical connections. Furthermore, since a shielding effect between the circuit board and the mother substrate is improved by the shield plate embedded in the connector member, disposed at the lower portion of the circuit board, an electronic circuit unit with good high frequency characteristics may be obtained.

Furthermore, the shield plate has a plurality of cutout portions, and the connector terminals are arranged to pass through the cutout portions vertically without contacting the shield plate, whereby a shielding effect is retained with a simple configuration while the shield plate does not contact the connector terminal.

Furthermore, the connector member has earth terminals which are electrically connected to the shield plate, and the earth terminals are electrically connectable to the second land portions of the mother substrate, whereby inductive noises such as electromagnetic waves which may affect the electronic components of the circuit board can be securely drained to the ground of the mother substrate via the shield plate.

Furthermore, the connector terminals are made of metallic plates, and are formed by the second terminals deformably extending from an outer surface of the insulating resin portion, whereby, even if there occurs a difference in expansion/contraction between the circuit board and the mother substrate by a temperature change under an outer environment, the difference in expansion/contraction is accommodated by deformation of the second terminals, which enhances the reliability of the electrical connections.

Furthermore, the first land portions and the first terminals are soldered, so that the circuit board and the connector member contact directly and a thinner structure is achieved, which reduces the size of the electronic circuit unit.

Furthermore, the circuit board includes connecting pieces soldered to the first land portions, the connecting pieces are made of metallic thin plates, the connecting pieces have first connections soldered to the first land portions, second connections soldered to the first terminals, and legs linking the first and second connections, and the first land portions and the first terminals are soldered by the legs while they are separated, whereby, even if there occurs a difference in expansion/contraction between the circuit board and the mother substrate by a temperature change under an outer environment, the difference in expansion/contraction is accommodated by deformation of the legs of the connecting pieces, which further enhances the reliability of the electrical connections compared with a direct connection.

## Claims

1. An electronic circuit unit, comprising:
a circuit board having an upper face on which electronic components are mounted to form a desired electric circuit and a lower face having a plurality of first land portions connected to the electric circuit; and
a connector member disposed at a lower portion of the circuit board;
wherein the connector member has an insulating resin portion, a metallic shield plate embedded in the insulating resin portion, and connector terminals which are provided with first terminals protruding from an upper face of the insulating resin portion and second terminals protruding from a lower face of the insulating resin portion; and
wherein the connector terminals are configured such that the first terminals over the upper face are electrically connected to the first land portions and the second terminals over the lower face are electrically connectable to second land portions of a mother substrate.

2. The electronic circuit unit according to Claim 1,
wherein the shield plate has a plurality of cutout portions, and the connector terminals are arranged to pass through the cutout portions vertically without contacting the shield plate.

3. The electronic circuit unit according to Claim 1 or 2,
wherein the connector member has earth terminals which are electrically connected to the shield plate, and the earth terminals are electrically connectable to the second land portions of the mother substrate.

4. The electronic circuit unit according to any of Claims 1 to 3,
wherein the connector terminals are made of metallic plates, and are formed by the second terminals deformably extending from an outer surface of the insulating resin portion.

5. The electronic circuit unit according to any of Claims 1 to 4,
wherein the first land portions and the first terminals are soldered.

6. The electronic circuit unit according to any of Claims 1 to 5,
wherein the circuit board includes connecting pieces soldered to the first land portions; the connecting pieces are made of metallic thin plates; the connecting pieces have first connections soldered to the first land portions, second connections soldered to the first terminals, and legs linking the first and second connections; and the first land portions and the first terminals are soldered by the legs while they are separated.
